(19) Europäisches Patentamt
European Patent Office
Office européen des brevets

(11) Veröffentlichungsnummer: **0 001 254**
**B1**

(12) **EUROPÄISCHE PATENTSCHRIFT**

(45) Veröffentlichungstag der Patentschrift: **22.09.82**

(51) Int. Cl.³: **G 03 F 7/08** C07C143/68

(21) Anmeldenummer: **78100876.8**

(22) Anmeldetag: **13.09.78**

# (54) Positiv arbeitende lichtempfindliche Kopiermasse enthaltend ein halogeniertes Naphthochinondiazid.

(30) Priorität: **22.09.77 DE 2742631**

(43) Veröffentlichungstag der Anmeldung:
**04.04.79 Patentblatt 79/7**

(45) Bekanntmachung des Hinweises auf die Patenterteilung:
**22.09.82 Patentblatt 82/38**

(84) Benannte Vertragsstaaten:
**BE CH DE FR GB NL SE**

(56) Entgegenhaltungen:
DE - B - 1 118 606
DE - B - 1 120 273
US - A - 3 046 121
US - A - 3 802 885

DERWENT JAPANESE PATENTS REPORT, Band 74, No. 32, Zusammenfassung, J 74 029685, Teil G
Zh. Fir. Khim. 1974, 48(7), S.1826—8

(73) Patentinhaber: **HOECHST AKTIENGESELLSCHAFT**
**Postfach 80 03 20**
**D-6230 Frankfurt/Main 80 (DE)**

(72) Erfinder: **Stahlhofen, Paul, Dr.**
**Walter-Gieseking-Strasse 28**
**D-6200 Wiesbaden (DE)**
Erfinder: **Erdmann, Fritz, Dr.**
**Hermann-Hesse-Strasse 39**
**D-6500 Mainz (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 001 254 B1

Positiv arbeitende lichtempfindliche Kopiermasse enthaltend ein halogeniertes Naphthochinondiazid.

Die Erfindung betrifft eine positiv arbeitende lichtempfindliche Kopiermasse. Die insbesondere für die Herstellung von Flachdruckplatten und Kopierlacken (Photoresists) bestimmt ist. Die Kopiermasse wird entweder vom Hersteller oder vom Verbraucher als lichtempfindliche Kopierschicht auf einen geeigneten Schichtträger aufgebracht. Dabei werden im allgemeinen Schichtträger aus Metallen, vorzugsweise aus Aluminium, verwendet.

Als positiv arbeitende Kopiermassen werden in der Praxis vor allem Massen mit o-Chinondiaziden, insbesondere Naphthochinon-(1,2)-diazid-(2)-sulfonsäureestern, als lichtempfindliche Verbindungen verwendet.

Lichtempfindliche Materialien für die Herstellung von positiv arbeitenden Flachdruckplatten sind in zahlreichen Druckschriften beschrieben worden, z.B. in den deutschen Patentschriften 938 233, 1 124 817, 1 109 521, 1 120 273 sowie in der DT—OS 19 04 764 und der US—PS 3 802 885. Lichtempfindliche Ester von o-Naphthochinondiazidsulfonsäuren mit halogensubstituierten Phenolen sind aus den deutschen Patentschriften 938 233, 1 422 474, 1 118 606 und 1 109 521 sowie aus der DT—OS 22 24 843 bekannt.

Bei den halogensubstituierten lichtempfindlichen o-Naphthochinondiazidsulfonsäureestern handelt es sich ausschließlich um solche Verbindungen, die noch freie unsubstituierte phenolische Gruppen enthalten. Derartige Schichten weisen im allgemeinen eine für die Praxis ungenügende Resistenz gegenüber den handelsüblichen wäßrig-alkalischen Entwicklern auf. Diese bekannten halogensubstituierten Naphthochinondiazidsulfonsäureester sind nur für die Herstellung von lichtempfindlichen Kopierschichten geeignet, an die keine hohen Qualitätsanforderungen gestellt werden. Ihre relativ geringe Auflagenhöhe und Lichtempfindlichkeit, ihre relativ schlechte Haftfestigkeit auf der Unterlage bzw. ihre ungenügende Entwicklerresistenz sind für die heutigen Anforderungen der Praxis ungenügend.

In der japanischen Patentanmeldung 74/029685 sind Naphthochinondiazidsulfonsäureester des 4,4′-Dihydroxy-3,3′-dichlordiphenylmethans, das in 5- und 5′-Stellung noch mindestens eine Hydroxymethylgruppe trägt, beschrieben. Auch diese Verbindung verhalten sich ähnlich wie die mit freien phenolischen Hydroxygruppen.

In einer Veröffentlichung von Martinenko, Gluchova und Kolzov in Zh. Fiz. Khim. 1974, 48 (7), S. 1826—28, sind Naphthochinondiazidsulfonsäureester von jodiertem 2,2-Bis-hydroxy-phenyl-propan beschrieben. Diese Verbindungen sollen gegenüber den nicht jodierten Verbindungen eine erhöhte Lichtempfindlichkeit aufweisen. Andere Eigenschaften werden dort nicht erwähnt.

Aufgabe der Erfindung ist es, eine positiv arbeitende lichtempfindliche Kopiermasse auf Basis von halogenierten Naphthochinondiaziden vorzuschlagen, die eine gute Haftung auf Druckplattenschichtträgern, eine hohe Entwicklerresistenz und Druckauflage aufweist.

Gegenstand der Erfindung ist eine lichtempfindliche Kopiermasse, die als lichtempfindliche Verbindung einen Naphthochinon-(1,2)-diazidsulfonsäureester enthält und die dadurch gekennzeichnet ist, daß dser Naphthochinon-(1,2)-diazidsulfonsäureester der allgemeinen Formel I

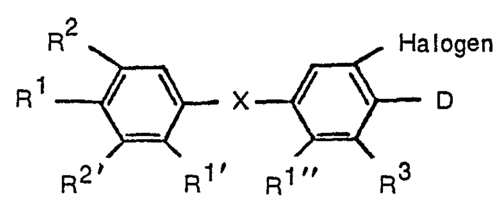

(I)

entspricht, worin

X eine Einfachbindung oder eine der Gruppen

$$—CO—, —S—, —SO_2— \text{ oder } —CH_2—$$

$R^1$, $R^{1'}$ und $R^{1''}$ gleich oder verschieden sind und H oder D bedeuten,

$R^2$ und $R^{2'}$ gleich oder verschieden sind und H oder Halogen bedeuten,

$R^3$ Halogen oder D und

D einen Naphthochinon-(1,2)-diazid-sulfonyloxyrest

bedeutet.

Die in der erfindungsgemäßen Kopiermasse verwendeten halogenierten o-Chinondiazide sind neu. Ihre Herstellung erfolgt in Analogie zu bekannten Verfahren durch Veresterung der entsprechenden halogenierten Phenolderivate mit o-Chinondiazidsulfonsäuren oder deren reaktionsfähigen Derivaten, z.B. den Sulfonsäurechloriden. Die Einführung der Halogenatome in die aromatischen Kerne der Phenolkomponenten erfolgt in an sich bekannter Weise. Die Bromierung wird z.B. am vorteilhaftesten in Eisessig bei Raumtemperatur durchgeführt. Zu diesem Zweck wird das entsprechende Ausgangsprodukt in Eisessig gelöst und bei Raumtemperatur unter Rühren und evtl. Kühlung tropfenweise mit der

berechneten Menge Brom versetzt. Nach Beendigung der Bromzugabe beginnt im allgemeinen schon die Ausfällung des halogenierten Produktes.

Zur Herstellung der Naphthochinon-(1,2)-diazid-sulfonsäureestern wird die halogenierte Phenolkomponente zusammen mit der entsprechenden molaren Menge Naphthochinon-(1,2)-diazid-(2)-5-sulfonsäurechlorid in Dioxan gelöst. Diese Lösung wird unter Rühren bei Raumtemperatur langsam mit 10%iger Sodalösung bzw. gesättigter Natriumbicarbonatlösung jeweils bis zur neutralen Reaktion versetzt. Nach einigen Stunden ist die Kondensation im allgemeinen beendet. Hat sich das Kondensationsprodukt hierbei abgeschieden, wird abgesaugt und der Ester mit Wasser säurefrei gewaschen und getrocknet. Scheidet sich der Naphthochinondiazid-sulfonsäureester aus der Reaktionslösung nicht ab, wied die Lösung unter gutem Rühren in Eiswasser gegeben und der hierbei ausgefällte Ester wie üblich weiter verarbeitet.

Als Halogene kommen, F, Cl, Br und J in Betracht, Cl und Br werden der einfacheren Zugänglichkeit und Handhabung wegen bevorzugt. Die Halogenatome können, wie aus der allgemeinen Formel I ersichtlich ist, nur an bestimmten Kernpositionen stehen. Bevorzugt werden Verbindungen, in denen alle Halogenatome in o-Stellung zu einer Naphthochinondiazidsulfonyloxygruppe stehen. Im allgemeinen nimmt die durch Einführung von Halogenatomen erzielte vorteilhafte Wirkung mit der Zahl der Halogenatome im Molekül zu. Deshalb werden im allgemeinen Verbindungen mit mindestens zwei Halogenatomen im Molekül bevorzugt. Verbindungen mit mehr als vier Halogenatomen können bereits eine Tendenz zu geringerer Löslichkeit aufweisen und werden daher im allgemeinen nicht bevorzugt.

Auch die Anzahl der Naphthochinondiazidsulfonyloxyreste im Molekül ist vorzugsweise größer als 1. Verbindungen mit zwei bis vier derartigen Resten werden in den meisten Fällen bevorzugt. Der Sulfonsäurerest steht im allgemeinen in der 4- oder 5-Stellung des Naphthochinon-(1,2)-diazids-(2). Die 5-Sulfonsäureester werden bevorzugt.

Im einzelnen können z.B. die folgenden Verbindungen Anwendung finden:

2,4,2′,4′ - Tetrahydroxy - 3,5,3′ - 5′ - tetrabrom - diphenyl - tetra[naphthochinon - (1,2) - diazid-(2) - 5 - sulfonsäureester],

2,4 - Dihydroxy - 3,5 - dibrom - benzophenon - bis[naphthochinon - (1,2) - diazid - (2) - 5 - sulfonsäureester],

4,4′ - Dihydroxy - 3,5,3′,5′ - tetrabrom - diphenylmethan - bis - [naphthochinon - (1,2) - diazid-(2) - 5 - sulfonsäureester],

2,3,4 - Trihydroxy - 5 - brom - benzophenon - tris[naphthochinon - (1,2) - diazid - (2) - 5 - sulfonsäureester],

2,4 - Dihydroxy - 3,5 - dichlor - benzophenon - bis[naphthochinon - (1,2) - diazid - (2) - 5 - sulfonsäureester],

2,4,2′,4′ - Tetrahydroxy - 3,5,3′,5′ - tetrabrom - diphenylsulfid - tetra[naphthochinon - (1,2)-diazid - (2) - 5 - sulfonsäureester,

2,4,2′,4′ - Tetrahydroxy - 3,5,3′,5′ - tetrabrom - diphenylsulfon - tetra[naphthochinon - (1,2)-diazid - (2) - 5 - sulfonsäureester.

Die Konzentration der halogenierten Chinondiazidderivate in der festen lichtempfindlichen Schicht kann in relativ weiten Grenzen schwanken. Im allgemeinen liegt der Anteil bei 3% bis 50%, vorzugsweise zwischen 7% und 25%, bezogen auf das Gewicht des Feststoffanteils der Kopierschicht. Gegebenenfalls kann auch ein Teil des halogenierten Chinondiazids durch eine entsprechende Menge eines bekannten halogenfreien Chinondiazids ersetzt werden, doch sollte vorzugsweise deer Mengenanteil an halogenierter Verbindung überwiegen.

Für die Herstellung der Kopierschichten wird die Kopiermasse auf Träger, beispielsweise Folien oder Platten aus Metallen, z.B. Aluminium, Zink, Kupfer oder Mehrmetallträger, Papier, Kunststoffolie oder Glas, als Lösung in organischen Lösungsmitteln, z.B. in Glykolmonomethyläther, Dioxan oder aliphatischen Ketonen, aufgebracht. Als Trägermaterial wird Aluminium, insbesondere anodisch oxydiertes Aluminium, bevorzugt. Die Kopierschichten können neben den lichtempfindlichen Chinondiaziden wasserunlösliche, in wäßrigen Alkalien lösliche oder mindestens quellbare Bindemittel enthalten. Hierdurch wird im allgemeinen die Gleichmäßigkeit des filmähnlichen Überzuges auf dem Träger sowie die Haftfestigkeit und Auflagenhöhe des Druckbildes erhöht. Als alkalilösliche bzw. in Alkali quellbare Bindemittel können natürliche Harze, wie Schellack und Kolophonium, sowie synthetische Harze, beispielsweise Mischpolymerisate aus Styrol und Maleinsäureanhydrid, Carbonylgruppen enthaltende Vinylpolymerisate, Acrylsäuremischpolymerisate, Polyvinylacetale und besonders niedere Phenol-Formaldehyd-Kondensationsharze, bevorzugt Novolake, Verwendung finden. Ferner können die Kopierschichten in an sich bekannter Weise noch Farbstoffe, Weichmacher, Haftvermittler und andere, für lichtempfindliche Schichten übliche Zusatz- und Hilfsmittel enthalten.

Die Beschichtung des Trägermaterials erfolgt in bekannter Weise durch Antrag mittels Walzen, Wannen oder Aufsprühen.

Zur Entwicklung wird die belichtete Flachdruckplatte mit einer schwach alkalischen Lösung behandelt, wobei die vom Licht getroffenen Anteile der Schicht entfernt werden und die unbelichteten Bildstellen auf dem Schichtträger zurückbleiben.

Von der so hergestellten Druckform können bei Verwendung der bevorzugten halogenierten Chinondiazide Drucke mit einer hohen Auflage hergestellt werden.

Die unter Verwendung der neuen Verbindungen hergestellten Druckplatten besitzen außerdem eine hohe praktische Lichtempfindlichkeit sowie eine verbesserte Resistenz gegenüber alkalischen Entwicklern. Hervorzuheben ist ferner die mit ihnen erzielte relativ steile Gradation, die in der drucktechnischen Praxis gewünscht wird, weil sie kopiertechnische Vorteile bringt. Die erfindungsgemäß bevorzugten Verbindungen selbst zeichnen sich durch eine gute Löslichkeit in den üblichen organischen Lösungsmitteln sowie durch eine gute Verträglichkeit mit den Bestandteilen der Kopierschicht aus.

In den folgenden Beispielen bedeutet ein Volumenteil (Vt) 1 ml, wenn für 1 Gewichtsteil (Gt) 1 g genommen wird.

Beispiel 1

Man löst

| | | |
|---|---|---|
| 1,25 Gt | des Veresterungsproduktes aus 1 Mol 3,5,3',5'-Tetrabrom-2,4,2',4'-tetrahydroxy-diphenyl und 4 Mol Naphthochinon(1,2)-diazide-(2)-5-sulfonsäurechlorid, |
| 6,10 Gt | eines Kresol-Formaldehyd-Novolaks mit dem Erweichungspunkt 105 bis 120°C nach DIN 53181, |
| 0,07 Gt | Kristallviolet, |
| 0,05 Gt | 2,3,4-Trihydroxy-benzophenon, |
| 0,14 Gt | Naphthochinon-(1,2)-diazid-(2)-4-sulfonsäurechlorid |

in einem Lösungsmittelgemisch aus

| | |
|---|---|
| 35 Vt | Äthylenglykolmonomethyläther und |
| 45 Vt | Tetrahydrofuran. |

Mit dieser Lösung beschichtet man eine elektrolytisch aufgerauhte und anodisierte Aluminiumfolie.

Zur Herstellung einer Druckform wird die so erhaltene Druckplatte unter einem Diapositiv belichtet und in bekannter Weise mit der folgenden Lösung

| | |
|---|---|
| 5,3 Gt | Natriummetasilikat · 9 Wasser, |
| 3,4 Gt | Trinatriumphosphat · 12 Wasser, |
| 0,3 Gt | Natriumdihydrogenphosphat (wasserfrei) |
| 91,0 Gt | Wasser |

entwickelt, wobei die belichteten Schichtbereiche entfernt werden. Von der so hergestellten Druckform werden in einer Offsetmaschine etwa 250 000 Drucke erhalten.

Ersetzt man bei sonst gleicher Herstellung der Druckform gemäß der oben angegebenen Rezeptur den bromierten o-Chinondiazidsulfonsäureester durch die gleiche Menge des entsprechenden nicht halogenierten o-Chinondiazidsulfonsäureesters, so werden Druckauflagen von nur 150 000 erhalten. Bemerkenswert ist ferner die hierbei resultierende schlechte Entwicklerresistenz und relativ weiche Gradation der Druckschablone.

Die kopier- und drucktechnischen Vorteile der neuen halogenierten o-Chinondiazidsulfonsäureester gegenüber den entsprechenden nicht halogenierten o-Chinondiazidsulfonsäureestern bzw. gegenüber den bekannten halogenierten Chinondiaziden lassen sich besonders leicht feststellen, wenn die o-Chinondiazidsulfonsäureester ohne Bindemittel und ohne sonstigen Zusatz in einem relativ dünnen Film (ca. 1,0 $g/m^2$) auf einen definierten Schichtträger aufgetragen werden. Bei der vergleichenden kopier- und drucktechnischen Untersuchung wird deutlich, daß durch die Einführung eines oder mehrerer Halogenatome in einem eine o-Naphthochinondiazidsulfonyloxygruppe tragenden Benzolkern gemäß der Erfindung die Druckauflage erhöht, die Resistenz gegenüber wäßrig alkalischem Entwickler verbessert, die Gradation härter und die Lichtempfindlichkeit erhöht werden.

In den folgenden Beispielen 2 bis 10 werden weitere Beschichtungslösungen angegeben, wobei ähnliche Ergebnisse erhalten werden. Wenn nicht gesondert vermerkt, entsprechen Herstellung und Verarbeitung der damit erhaltenen Flachdruckplatten den in Beispiel 1 beschriebenen Bedingungen.

Beispiel 2

Man löst

| | |
|---|---|
| 1,25 Gt | des Veresterungsproduktes aus 1 Mol 2,4-Dihydroxy-3,5-dibrombenzophenon und 2 Mol Naphthochinon-(1,2)-diazid-(2)-sulfonsäurechlorid |
| 6,00 Gt | des in Beispiel 1 angegebenen Kresol-Formaldehyd-Novolaks, |
| 0,06 Gt | Kristallviolett, |
| 0,18 Gt | Naphthochinon-(1,2)-diazid-(2)-4-sulfonsäurechlorid |

in einem Lösungsmittelgemisch aus

| | |
|---|---|
| 40 Vt | Äthylenglykolmonomethyläther und |
| 60 Vt | Tetrahydrofuran. |

Mit dieser Lösung beschichtet man eine elektrolytisch aufgerauhte und anodisierte Aluminiumfolie.

Beispiel 3

Man löst
1,40 Gt des Veresterungsproduktes aus 1 Mol 2,4-Dihydroxy-3,5-dibrombenzophenon und 2 Mol Naphthochinon-(1,2)-diazid-(2)-5-sulfonsäurechlorid,
6,20 Gt des in Beispiel 1 angegebenen Kresol-Formaldehyd-Novolaks,
0,05 Gt Kristallviolett,
0,03 Gt Sudangelb GGN (C.I. 11021)

in einem Lösungsmittelgemisch aus
35 Vt Äthylenglykolmonomethyläther und
45 Vt Tetrahydrofuran

Mit dieser Lösung beschichtet man eine elektrolytisch aufgerauhte und anodisierte Aluminiumfolie.

Beispiel 4

Man löst
1,50 Gt des Veresterungsproduktes aus 1 Mol 2,4-Dihydroxy-3,5-dibrom-benzophenon und 2 Mol Naphthochinon-(1,2)-diazid-(2)-5-sulfonsäurechlorid,
5,20 Gt eines Phenol-Formaldehyd-Novolaks mit 14% phenolischen OH-Gruppen und einem Erweichungspunkt von 110 bis 120°C nach DIN 53181,
0,20 Gt Polyvinylbutyral,
0,15 Gt Kristallviolett,
0,08 Gt Sudangelb GGN (C.I. 11021),
0,60 Gt Tris-(β-chloräthyl)-phosphat

in einem Lösungsgemisch aus
40 Vt Äthylenglykolmonomethyläther und
50 Vt Tetrahydrofuran.

Mit dieser Lösung beschichtet man eine durch Stahldrahtbürsten aufgerauhte Aluminiumfolie.

Beispiel 5

Man löst
1,20 Gt des Veresterungsproduktes aus 1 Mol 2,4-Dihydroxy-3,5-dichlor-benzophenon und 2 Mol Naphthochinon-(1,2)-diazid-(2)-5-sulfonsäurechlorid,
6,00 Gt des in Beispiel 4 angegebenen Phenol-Formaldehyd-Novolaks,
0,07 Gt Kristallviolett,
0,14 Gt Naphthochinon-(1,2)-diazid-(2)-4-sulfonsäurechlorid

in einem Lösungsmittelgemisch aus
40 Vt Äthylenglykolmonomethyläther,
50 Vt Tetrahydrofuran und
10 Vt Butylacetat.

Mit dieser Lösung beschichtet man eine elektrolytisch aufgerauhte und anodisierte Aluminiumfolie.

Beispiel 6

Man löst
1,45 Gt des Veresterungsproduktes aus 1 Mol 2,4-Dihydroxy-3,5-dichlor-benzophenon und 2 Mol Naphthochinon-(1,2)-diazid-(2)-5-sulfonsäurechlorid,
4,80 Gt des in Beispiel 4 angegebenen Phenol-Formaldehyd-Novolaks,
0,20 Gt Polyvinylbutyral,
0,45 Gt Naphthochinon-(1,2)-diazid-(2)-4-sulfonsäurechlorid,
0,12 Gt Kristallviolett-Base

in einem Lösungsmittelgemisch aus
30 Vt Äthylenglykolmonomethyläther und
30 Vt Tetrahydrofuran.

Schichtträger ist die Chromschicht einer Trimetallplatte aus Aluminium/Kupfer/Chrom.

Beispiel 7

Man löst

| | | |
|---|---|---|
| 0,87 Gt | des Veresterungsproduktes aus 1 Mol 2,3,4-Trihydroxy-5-brom-benzophenon und 3 Mol Naphthochinon-(1,2)-diazid-(2)-5-sulfonsäurechlorid, |
| 0,70 Gt | des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid, |
| 6,40 Gt | des in Beispiel 1 angegebenen Kresol-Formaldehyd-Novolaks, |
| 0,07 Gt | Kristallviolett-Base, |
| 0,16 Gt | Naphthochinon-(1,2)-diazid-(2)-4-sulfonsäurechlorid, |
| 0,60 Gt | Tris-(β-chloräthyl)phosphat |

in einem Lösungsmittelgemisch aus

| | |
|---|---|
| 30 Vt | Äthylenglykolmonomethyläther, |
| 40 Vt | Tetrahydrofuran, |
| 10 Vt | Butylacetat. |

Mit dieser Lösung beschichtet man eine elektrolytisch aufgerauhte und anodisierte Aluminiumfolie.

Beispiel 8

Dieses Beispiel beschreibt eine Kopierschichtlösung, die als Positiv-Kopierlack für verschiedene Zwecke, insbesondere für das Herstellen von Ätzschablonen, verwendet werden kann, z.B. beim Ätzen von Formteilen und Schildern und bei der Herstellung von Leiterbildern, insbesondere auch für die Mikroelektronik. Die Lösung ist lange haltbar. Die Beschichtungsart und die Schichtdicke können in weiten Grenzen den jeweiligen Anforderungen angepaßt werden. Nach der Belichtung sind die belichteten Gebiete hellgrün und heben sich von den kräftig blau gefärbt gebliebenen unbelichteten Gebieten kontrastreich ab. Die belichteten Gebiete lassen sich mit einem alkalischen Entwickler (pH etwa 12,8) mühelos entfernen.

Man löst

| | |
|---|---|
| 1,5 Gt | des Veresterungsproduktes aus 1 Mol 2,4-Dihydroxy-3,5-dibrom-benzophenon und 2 Mol Naphthochinon-(1,2)-diazid-(2)-5-sulfonsäurechlorid, |
| 10 Gt | des in Beispiel 4 angegebenen Phenol-Formaldehyd-Novolaks, |
| 2 Gt | eines Epoxyharzes aus Bisphenol A und Epichlorhydrin, mittleres Molekulargewicht unterhalb etwa 1000, |
| 0,1 Gt | Kristallviolett, |
| 0,3 Gt | Naphthochinon-(1,2)-diazid-(2)-4-sulfonsäurechlorid |

in 75 Vt Äthylenglykolmonoäthyläther,

Beispiel 9

Man löst

| | |
|---|---|
| 1,40 Gt | des Veresterungsproduktes aus 1 Mol 3,5,3',5'-Tetrabrom-4,4'-dihydroxydiphenylmethan und 2 Mol Naphthochinon-(1,2)-diazid-(2)-5-sulfonsäurechlorid, |
| 5,30 Gt | des in Beispiel 1 angegebenen Kresol-Formaldehyd-Novolaks, |
| 0,08 Gt | Kristallviolett-Base, |
| 0,08 Gt | 2,3,4-Trihydroxy-benzophenon, |
| 0,14 Gt | Naphthochinon-(1,2)-diazid-(2)-4-sulfonsäurechlorid |

in einem Lösungsmittelgemisch aus

| | |
|---|---|
| 30 Vt | Äthylenglykolmonomethyläther, |
| 30 Vt | Tetrahydrofuran und |
| 10 Vt | Butylacetat. |

Mit dieser Lösung beschichtet man eine elektrolytisch aufgerauhte und anodisierte Aluminiumfolie.

Beispiel 10

Man löst

| | |
|---|---|
| 1,40 Gt | des Veresterungsproduktes aus 1 Mol 2,4,2',4'-Tetrahydroxy-3,5,3',5'-tetrabromdiphenylsulfid und 4 Mol Naphthochinon-(1,2)-diazid-(2)-5-sulfonsäurechlorid, |
| 5,00 Gt | des in Beispiel 1 angegebenen Kresol-Formaldehyd-Novolaks, |
| 0,40 Gt | des in Beispiel 8 angegebenen Epoxyharzes, |
| 0,06 Gt | Kristallviolett-Base, |
| 0,05 Gt | Sudangelb GGN (C.I. 11021), |
| 0,08 Gt | 2,3,4-Trihydroxy-benzophenon |

in einem Lösungsmittelgemisch aus
40 Vt Äthylenglykolmonomethyläther und
50 Vt Tetrahydrofuran

Mit dieser Lösung beschichtet man eine elektrolytisch aufgerauhte und anodisierte Aluminiumfolie.

**Patentansprüche**

1. Lichtempfindliche Kopiermasse, die als lichtempfindliche Verbindung einen Naphthochinon-(1,2)-diazid-sulfonsäureester enthält, dadurch gekennzeichnet, daß der Naphthochinondiazidsulfonsäureester der allgemeinen Formel I

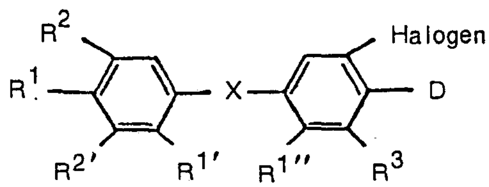

entspricht, worin
X eine Einfachbindung oder eine der Gruppen —CO—, —S—, —$SO_2$— oder —$CH_2$—,
$R^1$, $R^{1'}$ und $R^{1''}$ gleich oder verschieden sind und H oder D bedeuten,
$R^2$ und $R^{2'}$ gleich oder verschieden sind und H oder Halogen bedeuten,
$R^3$ Halogen oder D und
D einen Naphthochinon-(1,2)-diazidsulfonyloxyrest bedeutet.

2. Kopiermasse nach Anspruch 1, dadurch gekennzeichnet, daß sie eine Verbindung der allgemeinen Formel I enthält, die mindestens zwei Halogenatome enthält.

3. Kopiermasse nach Anspruch 1, dadurch gekennzeichnet, daß sie eine Verbindung der allgemeinen Formel I enthält, die zwei bis vier Naphthochinondiazidsulfonyloxyreste enthält.

4. Kopiermasse nach Anspruch 1, dadurch gekennzeichnet, daß sie in der lichtempfindlichen Kopierschicht ferner ein wasserunlösliches, in wäßrig-alkalischer Lösung lösliches oder mindestens quellbares Harz enthält.

5. Kopiermasse nach Anspruch 4, dadurch gekennzeichnet, daß das Harz ein Phenolharz ist.

6. Kopiermasse nach Anspruch 4, dadurch gekennzeichnet, daß sie, auf Festsubstanz bezogen, 7 bis 25 Gew.-% Naphthochinondiazidsulfonsäureester enthält.

**Claims**

1. A photosensitive copying composition containing a naphthoquinone-(1,2)-diazide-sulfonic acid ester as the photosensitive compound, characterized in that the naphthoquinone diazide sulfonic acid ester corresponds to the general formula I

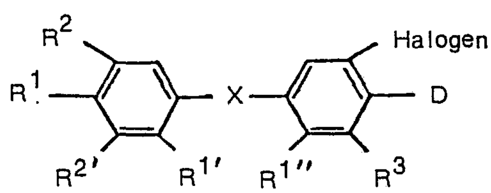

(I)

wherein:
X represents a single bond or one of the groups —CO—, —$CH_2$—, —S— or —$SO_2$—,
$R^1$, $R^{1'}$ and $R^{1''}$ are the same or different and stand for H or D,
$R^2$ and $R^{2'}$ are the same or different and stand for H or halogen,
$R^3$ represents halogen or D, and
D represents a naphthoquinone-(1,2)-diazide-sulfonyloxy radical.

2. A copying composition according to Claim 1, characterized in that it contains a compound of the general formula I containing at least two halogen atoms.

3. A copying composition according to Claim 1, characterized in that it contains a compound of the general formula I containing from two to four naphthoquinone diazide sulfonyloxy radicals.

4. A copying composition according to Claim 1, characterized in that it additionally contains in the photosensitive copying layer a resin which is insoluble in water, and is soluble or at least swellable in an aqueous alkaline solution.

5. A copying composition according to Claim 4, characterized in that the resin is a phenolic resin.

6. A copying composition according to Claim 4, characterized in that it contains from 7 to 25 per cent by weight of naphthoquinone diazide sulfonic acid ester, relative to the solids content.

**Revendications**

1. Composition photosensible contenant comme composé photosensible un ester de l'acide naphtoquinone -(1,2)-diazide-sulfonique, caractérisée en ce que l'ester de l'acide naphtoquinone-diazide sulfonique correspond à la formule générale I

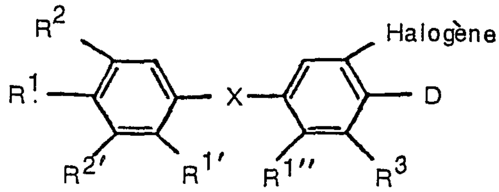

dans laquelle:

X est une liaison simple ou un des groupes suivants:

$$—CO—, —S—, —SO_2— \text{ ou } —CH_2—,$$

$R^1$, $R^{1'}$ et $R^{1''}$ sont identiques ou différents et signifient H ou D,

$R^2$ et $R^{2'}$ sont identiques ou différents et signifient H ou halogène,

$R^3$ est halogène ou D et

D signifie un reste naphtoquinone -(1,2)-diazide-sulfonyloxy.

2. Composition selon la revendication 1, caractérisé en ce qu'elle contient un composé de formule générale I renfermant au moins deux atomes d'halogène.

3. Composition selon la revendication 1, caractérisée en ce qu'elle contient un composé de formule générale I renfermant entre deux et quatre restes naphtoquinonediazidesulfonyloxy.

4. Composition selon la revendication 1, caractérisé en ce qu'elle contient dans la couche photosensible en outre une résine insoluble dans l'eau, soluble ou au moins susceptible de gonfler dans une solution aqueuse alcaline.

5. Composition selon la revendication 4, caractérisée en ce que la résine est une résine phénolique.

6. Composition selon la revendication 4, caractérisée en ce qu'elle contient par rapport à la substance solide, entre 7 et 25% en poids de l'ester de l'acide naphtoquinone-diazide-sulfonique.